# EUROPÄISCHE PATENTSCHRIFT

(11) **EP 0 849 635 B1**
(45) Veröffentlichungstag und Bekanntmachung des Hinweises auf die Patenterteilung: **21.11.2001**
(21) Anmeldenummer: 97122269.0
(22) Anmeldetag: 17.12.1997
(51) Int. Cl.: G03F 7/033

(54) **Strahlungsempfindliches Gemisch und daraus hergestellte Hochdruck-platte**
Radiation-sensitive composition and the letterpress-printing plate prepared therefrom
Composition sensible aux radiations et plaque typographique préparée à partir de cette composition

(30) Priorität: 20.12.1996 DE 19653603
(43) Veröffentlichungstag der Anmeldung: 24.06.1998
(73) Patentinhaber: BASF Drucksysteme GmbH, 70469 Stuttgart (DE)
(72) Erfinder: Stebani, Uwe, Dr., 55288 Spiesheim (DE); Loerzer, Thomas, Dr., 76829 Landau (DE); Leinenbach, Alfred, Dr., 67161 Gönnheim (DE)
(74) Vertreter: Isenbruck, Günter, Dr.

(56) Entgegenhaltungen:
- EP-A- 0 010 690
- EP-A- 0 373 436
- PATENT ABSTRACTS OF JAPAN vol. 006, no. 116 (P-125), 29.Juni 1982 & JP 57 045535 A (UNITIKA LTD), 15.März 1982,
- PATENT ABSTRACTS OF JAPAN vol. 017, no. 485 (P-1605), 2.September 1993 & JP 05 119476 A (TOPPAN PRINTING CO LTD), 18.Mai 1993,

## Beschreibung

Die Erfindung betrifft ein strahlungsempfindliches, insbesondere lichtempfindliches Gemisch, das als wesentliche Bestandteile
a) ein wasserlösliches oder in Wasser dispergierbares polymeres organisches Bindemittel,
b) eine mit dem Bindemittel verträgliche polymerisierbare Acryl- oder Methacrylsäureverbindung und
c) eine Verbindung enthält, die bei Einwirkung von aktinischer Strahlung die Polymerisation der Verbindung (b) zu initiieren vermag,
sowie strahlungsempfindliche Hoch- oder Reliefdruckplatten mit einem dimensionsbeständigen Schichtträger und einer Schicht aus dem strahlungsempfindlichen Gemisch.

Druckplatten, die eine strahlungsempfindliche Schicht aus einem Gemisch der vorstehend genannten Gattung enthalten, sind bekannt.

In der US-A 4 361 640 werden photopolymerisierbare Gemische beschrieben, die als Bindemittel Reaktionsprodukte aus Methylmethacrylat/Butylmethacrylat/Methacrylsäure-Terpolymerisaten, Polyamiden und Vinylpyrrolidon/Vinylacetat-Copolymerisaten aufweisen und ferner polymerisierbare Verbindungen und Photoinitiatoren enthalten und die zur Herstellung von Reliefdruckplatten geeignet sind. Diese Gemische lassen sich nicht mit reinem Wasser entwickeln.

In der DE-A 28 46 647 werden photopolymerisierbare Mischungen für die Herstellung von Druckplatten beschrieben, die als Bindemittel Polymere mit N-Vinylpyrrolidoneinheiten und Umsetzungsprodukte von Vinylalkohol-Polymeren mit Ethylenoxid enthalten. Diese Mischungen ergeben Druckplatten, deren Dimensionsstabilität für viele Zwecke nicht ausreicht.

In der JP-A 60/101531 werden photopolymerisierbare Gemische für die Herstellung von Druckplatten beschrieben, die ein wasserlösliches polymeres Bindemittel, z.B. Polyvinylalkohol, einen Polyvinylether, eine Hydroxyalkylcellulose, ein Polyethylenoxid, Polyvinylpyrrolidon oder Polyacrylsäure; einen Acryl- oder Methacrylsäureester oder ether von Polyglycerin oder ein Umsetzungsprodukt eines N-Alkylol(meth)acrylsäureamids als polymerisierbare Verbindung und einen Photopolymerisationsinitiator enthalten. Die mit diesen Gemischen erhaltenen Druckplatten haben eine für viele Zwecke nicht ausreichende Dimensionsstabilität und weisen geringere Zwischentiefen auf.

EP-A 10690 offenbart ein photopolymerisierbares Gemisch für die Herstellung von mit Wasser entwickelbaren Druck- und Reliefformen auf der Basis einer Photoinitiator enthaltenden, in Wasser löslichen oder dispergierbaren Mischung mindestens eines in Wasser löslichen oder dispergierbaren Polymeren mit einpolymerisierten N-Vinylpyrrolidon-Einheiten und/oder einem Polymeren mit Vinylalkohol-Einheiten und mindestens eines olefinisch ungesättigten photopolymerisierbaren Monomeren, wobei zumindest ein Teil des Polymeren ein wasserlösliches modifiziertes Vinylalkohol-Polymeres darstellt, das in einer Menge von 5 bis 75 Gew.-% im Polymermolekül chemisch gebundene O-CH₂-CH₂- Einheiten enthält.

JP-A-57045535 offenbart ein strahlungsempfindliches Gemisch, das PVA und ein wasserlösliches Polyamide enthält.

EP-A-373436 offenbart ein strahlungsempfindliches Gemisch, das N-vinylamide-Homopolymerisat enthält.

JP-A-5119476 offenbart ein strahlungsempfindliches Gemisch, das ein Vinylalkohol/vinylpyrrolidon-Copolymerisat enthält.

Aufgabe der Erfindung ist es, durch Strahlung, insbesondere durch Licht polymerisierbare, für die Herstellung von Hochdruckplatten geeignete Gemische vorzuschlagen, die sich nach dem Bestrahlen mit reinem Wasser entwickeln lassen und die Druckformen mit verbesserter Dimensionsstabilität, hervorragendem Farbübertrag, geringerer Rißanfälligkeit und guter Verarbeitbarkeit ergeben.

Die Erfindung geht aus von einem strahlungs- bzw. lichtempfindlichen Gemisch für die Herstellung von Druckplatten, insbesondere Hochdruckplatten, das
a) ein wasserlösliches oder in Wasser dispergierbares polymeres organisches Bindemittel,
b) eine mit dem Bindemittel verträgliche polymerisierbare Acryl- oder Methacrylsäureverbindung und
c) eine Verbindung enthält, wie bei Einwirkung von aktinischer Strahlung die Polymerisation der Verbindung (b) zu initiieren vermag.

Das erfindungsgemäße Gemisch ist dadurch gekennzeichnet, daß das Bindemittel
a1) ein Vinylalkoholeinheiten und ggf. Vinylestereinheiten enthaltendes Polymeres, dessen freie OH-Gruppen ausschließlich aus Vinylalkoholeinheiten herrühren, und
a2) ein Polymeres mit N-Vinyllactameinheiten, N-Vinylamin- oder N-Vinylamideinheiten oder Einheiten von vinyl-N-heterocyclischen Verbindungen enthält.

Erfindungsgemäß wird weiterhin eine strahlungsempfindliche Hochdruckplatte mit einem dimensionsbeständigen Schichtträger und einer strahlungsempfindlichen Schicht vorgeschlagen, die aus dem vorstehend definierten strahlungsempfindlichen Gemisch besteht.

Das erfindungsgemäße Gemisch unterscheidet sich von dem in EP-A-10690 offenbarten darin, daß in dem Vinylalkoholeinheiten enthaltenden Polymeren die freien OH-Gruppen ausschließlich aus Vinylalkoholeinheiten herrühren.

Die erfindungsgemäße Hochdruckplatte kann auf der strahlungsempfindlichen Schicht eine wasserlösliche oder in Wasser dispergierbare transparente Deckschicht und ggf. auf dieser Schicht oder unmittelbar auf der strahlungsempfindlichen Schicht eine abziehbare Deckfolie tragen.

Erfindungsgemäß wird schließlich auch ein Verfahren zum Herstellen einer Hochdruckform vorgeschlagen, das darin besteht, daß man eine strahlungsempfindliche Hochdruckplatte der vorstehend angegebenen Beschaffenheit bildmäßig mit aktinischer Bestrahlung bestrahlt, ggf. die Deckfolie vor oder nach dem Bestrahlen abzieht und die unbestrahlten Bereiche der strahlungsempfindlichen Schicht, ggf. zusammen mit der transparenten Deckschicht, mit Wasser oder einer wäßrigen Lösung auswäscht.

Als "strahlungsempfindlich" soll im Rahmen dieser Beschreibung jede Mischung oder Schicht verstanden werden, die durch aktinische, also chemisch wirksame Strahlung in ihren Eigenschaften, insbesondere in ihrer Löslichkeit, bleibend verändert wird. Als solche Strahlung wird bevorzugt kurzwelliges sichtbares oder langwelliges ultraviolettes Licht eingesetzt. Naturgemäß ist auch jede Strahlung höherer Energie, wie kurzwelliges UV-Licht, Elektronen-, Röntgen- oder γ- Strahlung, oder - bei geeigneter Sensibilisierung - auch längerwelliges Licht geeignet . Laserstrahlung kann ebenfalls eingesetzt werden.

Ein wesentliches Merkmal des erfindungsgemäßen Gemischs ist sein Gehalt an zwei verschiedenen polymeren Bindemitteln a₁ und a₂. Die beiden Bindemittel liegen bevorzugt in Mengenanteilen von 10 bis 50, insbesondere 15 bis 45 Gew.-% a₁ und 50 bis 90, insbesondere 55 bis 85 Gew.-% a₂ vor, jeweils bezogen auf die Gesamtmenge von a₁ + a₂.

Die Gesamtmenge an Bindemittel beträgt im allgemeinen 40 bis 95, bevorzugt 50 bis 90 Gew.-%, bezogen auf die Menge von a+b.

Das Vinylalkoholeinheiten enthaltende Polymere a₁ ist vorzugsweise ein vollständig oder teilweise verseifter Polyvinylester, insbesondere Polyvinylacetat. Die OH-Gruppen der Vinylalkoholeinheiten können wiederum teilweise mit polymerisierbaren (Meth)acrylsäuregruppen verestert sein, so daß das Polymere zugleich die Funktion einer polymerisierbaren bzw. vernetzbaren Verbindung hat und bei der Bestrahlung zusammen mit der niedermolekularen polymerisierbaren Verbindung b zu einem vernetzten unlöslichen Produkt zu reagieren vermag. Wesentlich für die Eignung des Polymeren a₁ ist es, daß es genügend Vinylalkoholeinheiten und ggf. Oxyalkyleneinheiten enthält, um die erforderliche Wasserlöslichkeit des Gemischs zu gewährleisten. Es enthält keine Einheiten mit Stickstoffatomen.

Das Polymere a₂ ist ein Vinylpolymeres mit seitenständigen Gruppen, die Stickstoffatome enthalten. Die Monomereinheiten, aus denen dieses Polymere aufgebaut ist, können Einheiten aus N-Vinyllactamen, z.B. N-Vinylpyrrolidon oder N-Vinyl-caprolactam; aus N-Vinylamiden, z.B. N-Vinylformamid oder N-Vinylacetamid; aus vinylheterocyclischen Verbindungen, z.B. N- oder C-Vinyl-imidazol, -oxazol, -imidazolin oder -oxazolin; oder aus N-Vinylaminen, z.B. N-Vinylamin, N-Vinylammoniumchlorid, N-Vinyl-N-alkyl-aminen und dergleichen enthalten. Die seitenständigen heterocyclischen oder Lactamreste können auch substituiert sein, z.B. durch Alkyl-, Aryl-, Hydroxyalkyl-, oder Hydroxyarylgruppen. Die Polymeren a₂ können Homo- oder Mischpolymere der genannten Monomeren sein und ggf. als Comonomere Vinylester-, Vinylalkohol- oder (Meth)acrylnitrileinheiten in kleinerer Menge, d.h. bis zu etwa 20, vorzugsweise nicht mehr als 10 mol-% enthalten.

Als polymerisierbare (Meth)acrylsäurederivate sind im wesentlichen die bei der Herstellung photopolymerisierbarer Gemische bekannten und gebräuchlichen Verbindungen geeignet. Verbindungen mit mindestens zwei polymerisierbaren (Meth)acryloylgruppen ein Molekül werden bevorzugt. Vorteilhaft sollten mindestens 50 Gew.-% der Menge der polymerisierbaren (Meth)acrylsäureverbindungen b mehr als eine polymerisierbare Gruppe enthalten. In vielen Fällen werden mit Vorteil Vertreter eingesetzt, die mindestens eine freie OH-Gruppe im Molekül aufweisen. Als polymerisierbare (Meth)acrylsäurederivate kommen insbesondere die Ester mit ein- oder mehrwertigen aliphatischen oder araliphatischen Alkoholen in Betracht.

Mit besonderem Vorteil werden Ester von niedermolekularen oder oligomeren Hydroxyverbindungen eingesetzt, die durch Umsetzen von Epoxiden mit zwei- oder mehrwertigen Alkoholen entstanden sind. Vorzugsweise sind in dem Gemisch 5 bis 100, besonders bevorzugt 50 bis 90 Gew.-% Ester von Epoxidumsetzungsprodukten und 0 bis 95, insbesondere 10 bis 50 Gew.-% Ester von anderen Hydroxyverbindungen, bezogen auf die Gesamtmenge an polymerisierbaren Verbindungen b, enthalten.

Beispiele für geeignete polymerisierbare Verbindungen sind (Meth)acrylsäureester von Alkanolen mit 1 bis 20 Kohlenstoffatomen, wie Methylmethacrylat, Ethylacrylat, Propyl(meth)acrylat, Isopropyl(meth)acrylat, n-Butyl(meth)acrylat, Isobutyl(meth)acrylat, tert.-Butyl(meth)acrylat, Hexyl(meth)acrylat, Cyclohexyl(meth)acrylat, 2-Ethyl-hexyl(meth)acrylat, Lauryl(meth)acrylat oder Benzyl(meth)acrylat; (Meth)acrylester mehrwertiger Alkohole mit 2 bis 20 Kohlenstoffatomen, z.B. 2-Hydroxy-ethyl(meth)acrylat, 2-Hydroxy-propyl(meth)acrylat, Ethylenglykoldi(meth)acrylat, Polyethylenglykoldi(meth)acrylat, Butandiol-1,4-di(meth)acrylat, Neopentylglykol-di(meth)acrylat, 3-Methylpentandioldi(meth)acrylat, 1,1,1-Trimethylol-propantri(meth)acrylat, Di-, Tri-, und Tetraethylenglykoldi(meth)acrylat, Tripropylenglykoldi(meth)acrylat oder Pentaerythrittetra(meth)acrylat, des weiteren Polyethylenglykolmono(meth)acrylat-monomethylether, 2-Diethylamino-ethylacrylat, ein Umsetzungsprodukt aus 1 mol Glycerin, 1 mol Epichlorhydrin und 3 mol Acrylsäure sowie Glycidylmethacrylat und Bisphenol-A-diglycidetheracrylat.

Ebenso eignen sich Derivate des Acrylamids und des Methacrylamids, z.B. Ether ihrer N-Methylolderivate mit ein- und mehrwertigen Alkoholen, wie Ethylenglykol, Glycerin, 1,1,1-Trimethylol-propan, oligomeren oder polymeren Ethylenoxidderivaten. Diese eignen sich besonders, wenn Polyvinylalkohol als Bindemittel eingesetzt wird. Geeignet sind auch Epoxid- und Urethan(meth)acrylate, wie sie z.B. durch Umsetzung von Bisphenol-A-diglycidylether mit (Meth)acrylsäure oder durch Umsetzung von Diisocyanaten mit Hydroxyalkyl(meth)acrylaten und ggf. mit hydroxylgruppenhaltigen Polyestern oder Polyethern erhalten werden können. Weiterhin einsetzbare Verbindungen sind Ester der Acryl- oder Methacrylsäure, insbesondere solche mit niedrigem Dampfdruck und solche, die mit Verträglichkeitsvermittlern modifiziert sind, z.B. mit Hydroxy-, Amido-, Sulfoester- oder Sulfonamidgruppen. Auch Gemische der o.g. ethylenisch ungesättigten Verbindungen können eingesetzt werden. Die polymerisierbaren ethylenisch ungesättigten Verbindungen (b) können in der strahlungsempfindlichen Schicht in Mengen von 5 bis 60 vorzugsweise 10 bis 50 Gew.-%, bezogen auf die Gesamtmenge von Bindemittel (a) und polymerisierbarer Verbindung (b), enthalten sein.

Als Photoinitiatoren oder Photoinitiatorsysteme (c) kommen die für lichtempfindliche Aufzeichnungsmateralien allgemein üblichen in Frage, z.B. radikalliefernde Photoinitiatoren, wie Benzoin oder Benzoinderivate, Benzoinether geradkettiger oder verzweigter Monoalkohole mit 1 bis 6 Kohlenstoffatomen, z.B. Benzoinmethyl-, -ethyl,- -isopropyl-, -n-butyl-, -isobutylether, symmetrisch oder unsymmetrisch substituierte Benzilketale, wie Benzildimethylketal, Benzil-1-methyl-1-ethylketal, Diarylphosphinoxide, wie 2,4,6-Trimethyl-benzoyldiphenylphosphinoxid oder 2,6-Dimethoxy-benzoyldiphenylphosphinoxid, 2,4,6-Trimethyl-benzoylphenylphosphinsäureethylester oder Acyldiarylphosphinoxide gemäß DE-A 29 09 992, Diacylphosphinoxide oder substituierte und unsubstituierte Chinone, wie Ethylanthrachinon, Benzanthrachinon, Benzophenon oder 4,4'-Bis(dimethylamino)-benzophenon. Sie können allein oder im Gemisch miteinander oder in Verbindung mit Coinitiatoren verwendet werden, z.B. Ethylanthrachinon mit 4,4'-Bis(dimetbylamino)-benzophenon, Benzoinmethylether mit Triphenylphosphin, Diacylphosphinoxide mit tertiären Aminen oder Acyldiarylphosphinoxide mit Benzildimethylketal.

Die Photoinitiatoren sind in dem strahlungsempfindlichen Gemisch üblicherweise in Mengen von 0,1 bis 10, vorzugsweise 0,2 bis 5 Gew.-%, enthalten.

Außer polymeren Bindemitteln, damit verträglichen polymerisierbaren Verbindungen und Photoinitiatoren können in dem strahlungsempfindlichen Gemisch weitere Hilfs- und Zusatzstoffe enthalten sein, z.B. können in Mengen von 0,001 bis 2%, bezogen auf das Gesamtgewicht des strahlungsempfindlichen Gemischs, Inhibitoren gegen die thermische Polymerisation, die keine nennenswerte Eigenabsorption in dem aktinischen Bereich aufweisen, in dem der Photoinitiator absorbiert, zugesetzt werden, z.B. 2,6-Di-tert.-butyl-p-kresol, Hydrochinon, p-Methoxyphenol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, z.B. die Kalium-, Calcium- oder Aluminiumsalze des N-Nitroso-cyclohexylhydroxylamins.

Auch geeignete Farbstoffe, Pigmente oder photochrome Zusätze können dem erfindungsgemäßen strahlungsempfindlichen Gemisch in einer Menge von 0,0001 bis 2 Gew.-% zugesetzt sein. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie ebensowenig wie die Inhibitoren die Photopolymerisation der Gemische stören. Geeignet sind z.B. die löslichen Phenazinium-, Phenoxazinium-, Acridinium- und Phenothiaziniumfarbstoffe, wie Neutralrot (C.I. 50040), Safranin T (C.I. 50240), Rhodanilblau, das Salz bzw. Amid aus Rhodamin D (Basic Violet 10, C.I. 45170), Methylenblau B (C.I. 52015), Thioninblau G (C.I. 52025), oder Acridinorange (C.I. 46005); sowie auch Solvent Black 3 (C.I. 26150). Diese Farbstoffe können auch zusammen mit einer hinreichenden Menge eines Reduktionsmittels verwendet werden, welches den Farbstoff in Abwesenheit von aktinischem Licht nicht reduziert, bei Belichtung jedoch den Farbstoff im angeregten Elektronenzustand reduzieren kann. Beispiele solcher milder Reduktionsmittel sind Ascorbinsäure, Anethol, Thioharnstoffe, z.B. Diethylallylthioharnstoff, insbesondere N-Allylthioharnstoff, sowie Hydroxylaminderivate, insbesondere Salze des N-Nitroso-cyclohexylhydroxylamins, vorzugsweise die Kalium-, Calcium- und Aluminiumsalze. Letztere können, wie erwähnt,zugleich als Inhibitoren der thermisch initiierten Polymerisation dienen. Die Reduktionsmittel können im allgemeinen in Mengen von 0,005 bis 5 Gew.-% zugesetzt werden, wobei sich in vielen Fällen der Zusatz des 3- bis 10-fachen der Farbstoffmenge bewährt hat.

Die Herstellung des strahlungsempfindlichen Gemischs aus den einzelnen Bestandteilen kann in der üblichen Weise durch Mischen der Bestandteile mit Hilfe bekannter Mischmethoden und durch Verarbeitung dieser Mischung zur strahlungsempfindlichen Schicht mit Hilfe bekannten Techniken, wie Gießen aus Lösung, Kalandrieren oder Extrudieren, erfolgen, wobei diese Maßnahmen auch in geeigneter Weise miteinander kombiniert werden können. Die Stärke der Schicht beträgt zweckmäßigerweise ca. 0,1 bis 2 insbesondere 0,2 bis 1 mm.

Die strahlungsempfindliche Schicht wird bei der erfindungsgemäßen Hochdruckplatte gegebenenfalls mittels einer Haftschicht auf einen dimensionsstabilen Träger aufgebracht. Beispiele geeigneter dimensionsstabiler Träger sind Platten, Folien sowie konische und zylindrische Röhren (sleeves) aus Metallen wie Stahl, Aluminium, Kupfer oder Nickel oder aus Kunststoffen, wie Polyethylenterephthalat (PET), Polybutylenterephthalat, Polyamid und Polycarbonat, gegebenenfalls auch Gewebe und Vliese, wie Glasfasergewebe sowie Verbundmaterialien aus Glasfasern und Kunststoffen.

Als Haftschichten können unter anderem Polyurethanhaftlacke, z.B. gemäß DE-A-30 45 516 auf Basis von polyisocyanatvernetzten Polyether- oder Polyesterlacken in Schichtdicken zwischen 0,5 und 50, insbesondere zwischen 2 und 30 *µ*m dienen.

Oberlackschichten können sich auf der von der Trägerschicht abgewandten Seite der Haftschicht befinden, weisen Schichtdicken zwischen 0,1 und 50, insbesondere 1 und 10 *µ*m auf und können z.B. aus verdünnter wäßrig/alkoholischer Lösung von (z.B. zu 80 mol%) teilverseiften Polyvinylestern, Phenylglycerinethermonoacrylat und Glyoxal, Trocknen und Einbrennen erhalten werden.

Auf der strahlungsempfindlichen Schicht befindet sich ggf. eine Deckschicht aus einem wasserlöslichen oder in Wasser dispergierbaren Polymeren, die immer dann benötigt wird, wenn die darunter befindliche wasser- oder wäßrig/alkoholisch entwickelbare photopolymerisierbare Schicht so klebrig ist, daß beim Auflegen des photographischen Negativs die vorhandene Luft nicht gleichmäßig enfernt werden kann und in der Folge sogenannte Vakuumfehler beim Belichten entstehen, oder aber daß sich das Negativ nicht mehr sauber von der Schichtoberfläche abtrennen läßt.

Die photopolymerisierbare Schicht kann gegen mechanische Beschädigungen durch eine Schutzfolie geschützt werden, die sich entweder auf der photopolymerisierbaren Schicht oder auf der Deckschicht befindet (vgl. z.B. Ullmanns Enzyclopedia of Industrial Chemistry, Band A13, Seite 629).

Zur Entwicklung der erfindungsgemäßen Hochdruckplatte kann die durch aktinisches Licht vernetzbare Schicht mit den für Photopolymerdruckplatten üblichen UV-Lichtquellen (Hauptemissionsbereich 320 bis 400 nm) belichtet werden, z.B. Philips TL 10R40W oder BASF ® nyloprint 40W BL 366). Der nyloprint-Belichter 80 x 107 ist beispielsweise mit 18 Hochleistungs- UV-Leuchtstoffröhren dieser Art bestückt.

Das Auswaschen unbelichteter Bereiche von Photopolymerdruckplatten, Nachspülen und Vortrocknen kann mit den für diesen Zweck handelsüblichen Auswaschsystemen durchgeführt werden. So arbeitet beispielsweise das ®nyloprint-Auswaschsystem DW 85 nach dem Reibeauswaschprinzip. Die Trocknung kann dann in sogenannten Durchlauftrocknern erfolgen, beispielsweise in einem ® nyloprint Durchlauftrockner DT 85.

Die Herstellung des strahlungs- bzw. lichtempfindlichen Gemische in den folgenden Beispielen erfolgte jeweils in gleicher Weise und ist im Beispiel 1 ausführlich beschrieben. Die Belichtung und Entwicklung der erhaltenen Druckplatten erfolgte jeweils in gleicher Weise und ist in Beispiel 1 ausführlich beschrieben. Die Auswertung der belichteten und entwickelten Druckformen wurde optisch mittels Stereomikroskop und Bildanalysegerät durchgeführt.

### Beispiel 1

50 Gewichtsteile eines teilverseiften Polyvinylacetats (Verseifungsgrad 88 mol-%, mittleres Molekulargewicht 30 000) wurden in 40 Gewichtsteilen Methylenchlorid aufgeschlämmt und dann mit 60 Gewichtsteilen Methacrylsäureanhydrid versetzt. Das inhomogene Reaktionsgemisch wurde 20 Stunden bei 60°C gerührt, danach das Umsetzungsprodukt abgetrennt und getrocknet. Das erhaltene Polymere enthielt 15% Methacryloylgruppen.

27 Gewichtsteile des vorstehend beschriebenen Polymeren mit seitenständigen Methacryloylgruppen und 35 Gewichtsteile eine Copolymeren aus 50 % N-Vinylpyrrolidon und 50 % N-Vinylimidazol (K-Wert 17) wurden in einem Wasser/n-Propanol-Gemisch (70:30) bei 85°C so lange gerührt, bis eine homogene Lösung entstanden war. Anschließend wurden 34 Gewichtsteile 1,4-Bis(3-acryloyloxy-2-hydroxy-propoxy)butan, 3 Gewichtsteile Benzildimethylketal, 0,2 Gewichtsteile des Kaliumsalzes von N-Nitroso-cyclohexylhydroxylamin und 0,005 Gewichtsteile Safranin T (C.I. 50240) zugegeben und das Gemisch bei 85°C gerührt, bis eine homogene Lösung entstanden war. Diese Lösung wurde mit dem gleichen Wasser/n-Propanol-Gemisch auf etwa 40% Feststoffanteil verdünnt und dann auf eine 120 *µ*m dicke Folie aus biaxial gerecktem und thermofixiertem Polyethylentherephtalat derart vergossen, daß sich nach dem Trocknen eine 800 *µ*m dicke lichtempfindliche Schicht ergab.

Auf die lichtempfindliche Schicht wurde eine 10 *µ*m dick mit einem Polyurethanhaftlack aus polyisocyanatvernetztem Polyether beschichtete 250 *µ*m dicke Polyethylenterephtalatfolie kaschiert und die so erhaltene lichtempfindliche Druckplatte mit einer Gesamtdicke von 1050 *µ* m 3 Stunden bei 60°C in einem Trockenschrank getrocknet. Die lichtempfindliche Druckplatte wurde durch ein Testnegativ in einem handelsüblichen UV-Vakuumbelichter vom Format 80 x 107 cm belichtet und in einem handelsüblichen Auswaschgerät mit Wasser entwickelt. Es wurde eine druckfertige flexible Hochdruckplatte mit hervorragender Dimensionsstabilität, sehr guten Zwischentiefen und sehr spitzer Kopie erhalten.

Ein Druckversuch mit der beschriebenen Platte ergab einen sehr scharfen Ausdruck und 200 000 Kopien, ohne daß Rißbildung oder Qualitätsverlust beobachtet werden konnte. Die Ergebnisse der optischen Auswertung und der Prüfung der Dimensionsstabilität sind in Tabelle 1 zusammengestellt.

### Beispiel 2

Ein lichtempfindliches Gemisch wurde wie in Beispiel 1 beschrieben hergestellt, wobei aber ein anstelle des Vinylpyrrolidon/Vinylimidazol-Copolymeren die gleiche Menge eines Copolymeren aus Vinylpyrrolidon und N-Vinyl-caprolactam (50:50; K-Wert 65) eingesetzt wurde. Es wurden Druckplatten mit hervorragender Dimensionsstabilität und sehr guten Zwischentiefen bei gleichzeitiger Verkürzung der Belichtungszeit erhalten. Ein Druckversuch ergab 250 000 sehr scharfe Drucke, ohne daß Rißbildung oder Qualitätsverlust beobachtet werden konnte. Die Ergebnisse der optischen Auswertung sowie die Resultate der Tests zur Dimensionsstabilität sind in Tabelle 1 zusammengefaßt.

### Beispiel 3

Ein lichtempfindliches Gemisch wurde wie in Beispiel 1 beschrieben hergestellt, wobei aber anstelle des Vinylpyrrolidon/Vinylimidazol-Copolymeren die gleiche Menge eines Terpolymeren aus Vinylpyrrolidon, Vinylalkohol und Vinylacetat (60:28:12) eingesetzt wurde. Es wurden Druckplatten mit hervorragender Dimensionsstabilität und sehr guten Zwischentiefen erhalten. Ein Druckversuch ergab 300 000 scharfe Drucke, ohne daß Rißbildung oder Qualitätsverlust zu beobachten war. Die Ergebnisse der optischen Auswertung sowie der Prüfung der Dimensionsstabilität sind in Tabelle 1 zusammengefaßt.

### Beispiel 4

Ein lichtempfindliches Gemisch wurde wie in Beispiel 1 beschrieben hergestellt, wobei aber anstelle des Vinylpyrrolidon/Vinylimidazol-Copolymeren die gleiche Menge Polyvinylcaprolactam eingesetzt wurde. Es wurden Druckplatten mit sehr guter Dimensionsstabilität und sehr guten Zwischentiefen erhalten. Ein Druckversuch ergab 200 000 fehlerlose, scharfe Drucke, ohne daß Rißbildung oder Qualitätsverlust beobachtet werden konnte. Die Ergebnisse der optischen Auswertung sowie der Prüfung der Dimensionsstabilität sind in Tabelle 1 angegeben.

### Vergleichsbeispiel 1 (V 1)

Ein lichtempfindliches Gemisch wurde wie in Beispiel 1 beschrieben hergestellt, wobei aber als Bindemittel ausschließlich 72 Gewichtsteile des in Beispiel 1 beschriebenen Polymeren mit seitenständigen Methacryloylgruppen eingesetzt wurden. Bei der Verarbeitung wurden harte, unflexible Druckplatten mit schlechter Dimensionsstabilität und geringen Zwischentiefen erhalten. Im Druckversuch ergaben die Platten einen unscharfen Ausdruck und zeigten bereits nach 50 000 Drucken erste Rißbildungen. Die Ergebnisse der optischen Auswertung sowie der Prüfung der Dimensionsstabilität sind in Tabelle 1 angegeben.

### Vergleichsbeispiel 2 (V 2)

Ein lichtempfindliches Gemisch wurde wie in Beispiel 1 beschrieben hergestellt, wobei aber anstelle des Vinylpyrrolidon/Vinylimidazol-Copolymeren die gleiche Menge eines Vinylacetat/Ethylenoxid-Copolymeren eingesetzt wurde.

Es wurden flexible Druckplatten mit sehr schlechter Dimensionsstabilität erhalten. Im Druckversuch ergaben die Platten einen etwas zu fetten, im Vergleich zu den erfindungsgemäßen Platten schlechteren Ausdruck. Die Ergebnisse der optischen Auswertung sowie der Prüfung der Dimensionsstabilität sind in Tabelle 1 angegeben.

Zur Beurteilung der Dimensionsstabilität wurde ein 20 x 20 cm großes Stück der jeweiligen Platte vollflächig belichtet und ausgewaschen. Anschließend wurden die belichteten Platten in einem Klimaschrank bei 25°C und unterschiedichen relativen Luftfeuchten gelagert. Als relative Luftfeuchten wurden nacheinander 20%, 30%, 40%, 50% und 60% gewählt. Um die Einstellung eines Gleichgewichts zwischen Luftfeuchte und belichteter und entwickelter Platte zu gewährleisten, wurden die Platten jeweils zwei Tage in der jeweiligen Luftfeuchte gelagert. Als Kriterium für die Dimensionsstabilität wurde die Planlage der belichteten und entwickelten Plattenstücke an den Ecken gemessen und als Bewertungsskala eingeführt: höchste Erhöhung der einzelnen Ecken vom Untergrund um 0-10 mm = sehr gut (++), 11-20 mm = gut (+), 21-30 mm = schlecht (-), mehr als 30 mm = sehr schlecht (--).

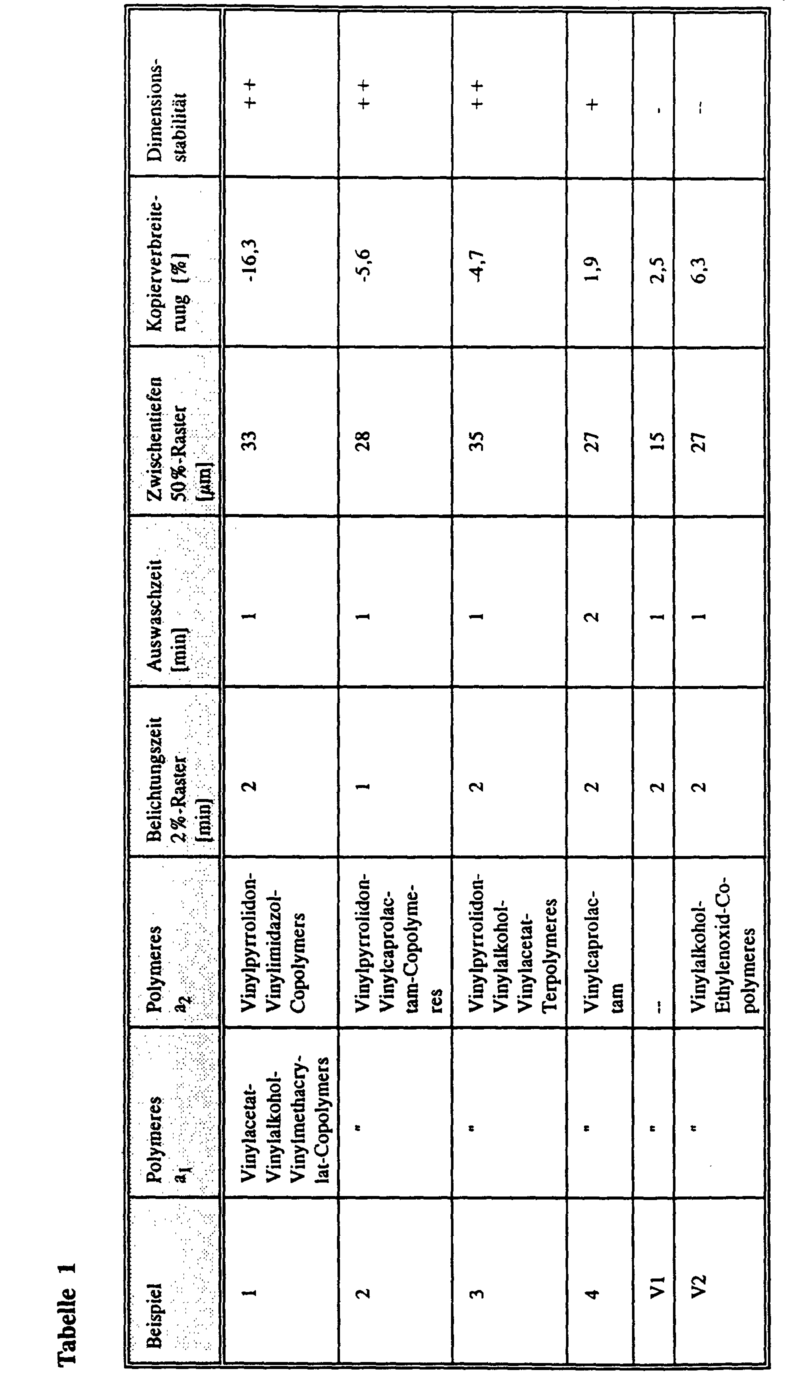

## Patentansprüche

1. Strahlungsempfindliches Gemisch, enthaltend
a) ein wasserlösliches oder in Wasser dispergierbares polymeres organisches Bindemittel,
b) eine mit dem Bindemittel verträgliche polymerisierbare Acryl- oder Methacrylsäureverbindung und
c) eine Verbindung, die bei Einwirkung von aktinischer Strahlung die Polymerisation der Verbindung (b) zu initiieren vermag,
**dadurch gekennzeichnet, daß** das Bindemittel
a₁) ein Vinylalkoholeinheiten und ggf. Vinylestereinheiten enthaltendes Polymeres, dessen freie OH-Gruppen ausschließlich aus Vinylalkoholeinheiten herrühren, und
a₂) ein Polymeres mit N-Vinylamideinheiten, N-Vinyllactameinheiten oder Einheiten von vinyl-N-heterocyclischen Verbindungen
enthält.

2. Strahlungsempfindliches Gemisch nach Anspruch 1, **dadurch gekennzeichnet, daß** es 10 bis 50% des Polymeren (a₁) und 50 bis 90% des Polymeren (a₂), bezogen auf das Gewicht von a₁ + a₂, enthält.

3. Strahlungsempfindliches Gemisch nach Anspruch 1, **dadurch gekennzeichnet, daß** es 40 bis 95 % Bindemittel (a) und 5 bis 60% Acryl- oder Methacrylsäureverbindung (b), bezogen auf das Gewicht von a+b, enthält.

4. Strahlungsempfindliches Gemisch nach Anspruch 1, **dadurch gekennzeichnet, daß** es 0,05 bis 10%, bezogen auf das Gewicht der nichtflüchtigen Bestandteile, an Polymerisationsinitiator (c) enthält.

5. Strahlungsempfindliches Gemisch nach Anspruch 1, **dadurch gekennzeichnet, daß** die Vinylalkoholeinheiten des Polymeren (a₁) teilweise mit Acryl- oder Methacrylsäure verestert sind.

6. Strahlungsempfindliches Gemisch nach Anspruch 1, **dadurch gekennzeichnet, daß** das Polymere (a₂) ein Homo- oder Copolymeres von Vinylpyrrolidon, Vinylimidazol, Vinylimidazolin, Vinyloxazol, Vinyloxazolin oder Vinylformamid.

7. Strahlungsempfindliche Hochdruckplatte mit einem dimensionsbeständigen Schichtträger und einer strahlungsempfindlichen Schicht, die aus einem Gemisch gemäß einem der Ansprüche 1 bis 6 besteht.

8. Strahlungsempfindliche Hochdruckplatte nach Anspruch 7, **dadurch gekennzeichnet, daß** sie auf der strahlungsempfindlichen Schicht eine wasserlösliche oder in Wasser dispergierbare transparente Deckschicht trägt.

9. Strahlungsempfindliche Hochdruckplatte nach Anspruch 7 oder 8, **dadurch gekennzeichnet, daß** sie auf ihrer Oberfläche eine abziehbare Deckfolie trägt.

10. Verfahren zum Herstellen einer Hochdruckform, **dadurch gekennzeichnet, daß** man eine Hochdruckplatte nach einem der Ansprüche 7 bis 9 bildmäßig mit aktinischer Strahlung bestrahlt, ggf. die Deckfolie vor oder nach dem Bestrahlen abzieht und die unbestrahlten Bereiche der strahlungsempfindlichen Schicht, ggf. zusammen mit der transparenten Deckschicht, mit Wasser oder einer wäßrigen Lösung auswäscht.

## Claims

1. A radiation-sensitive mixture containing
a) a water-soluble or water-dispersible polymeric organic binder,
b) a polymerizable acrylic or methacrylic acid compound compatible with the binder and
c) a compound which, under the action of actinic radiation, is capable of initiating the polymerization of the compound (b),
wherein the binder contains
a₁) a polymer which contains vinyl alcohol units and may contain vinyl ester units and whose free OH groups originate exclusively from vinyl alcohol units and
a₂) a polymer having N-vinylamide units, N-vinyllactam units, or units of vinyl-N-heterocyclic compounds.

2. A radiation-sensitive mixture as claimed in claim 1, which contains from 10 to 50% of polymer (a₁) and from 50 to 90% of polymer (a₂), the percentages being based on the weight of a₁ + a₂.

3. A radiation-sensitive mixture as claimed in claim 1, which contains from 40 to 95% of binder (a) and from 5 to 60% of acrylic or methacrylic acid compound (b), the percentages being based on the weight of a+b.

4. A radiation-sensitive mixture as claimed in claim 1, which contains from 0.05 to 10%, based on the weight of the nonvolatile components, of polymerization initiator (c).

5. A radiation-sensitive mixture as claimed in claim 1, wherein some of the vinyl alcohol units of the polymer (a₁) are esterified with acrylic or methacrylic acid.

6. A radiation-sensitive mixture as claimed in claim 1, wherein the polymer (a₂) is a homo- or copolymer of vinylpyrrolidone, vinylimidazole, vinylimidazoline, vinyloxazole, vinyloxazoline or vinylformamide.

7. A radiation-sensitive letterpress printing plate having a dimensionally stable substrate and a radiation-sensitive layer which consists of a mixture as claimed in any of claims 1 to 6.

8. A radiation-sensitive letterpress printing plate as claimed in claim 7, which carries a water-soluble or water-dispersible transparent release layer on the radiation-sensitive layer.

9. A radiation-sensitive letterpress printing plate as claimed in claim 7 or 8, which carries a removable cover sheet on its surface.

10. A process for the production of a letterpress printing plate, wherein a letterpress printing plate as claimed in any of claims 7 to 9 is exposed imagewise to actinic radiation, if required the cover sheet is removed before or after exposure and the unexposed parts of the radiation-sensitive layer, if required together with the transparent release layer, are washed out with water or an aqueous solution.

## Revendications

1. Mélange sensible aux rayonnements, contenant
a) un liant organique polymère soluble dans l'eau ou dispersable dans l'eau,
b) un dérivé acrylique ou méthacrylique polymérisable, compatible avec le liant, et
c) un composé qui, sous l'action de radiations actiniques, est capable de déclencher la polymérisation du composé (b),
**caractérisé par le fait que** le liant contient
a₁) un polymère contenant des motifs d'alcool vinylique et le cas échéant des motifs d'ester vinylique, dont les groupes OH libres proviennent exclusivement de motifs d'alcool vinylique, et
a₂) un polymère à motifs de N-vinylamide, à motifs de N-vinyllactames ou à motifs de dérivés vinyl-N-hétérocycliques.

2. Mélange sensible aux rayonnements selon la revendication 1, **caractérisé par le fait qu'**il contient de 10 à 50 % du polymère (a₁) et de 50 à 90 % du polymère (a₂) par rapport au poids de (a₁) + (a₂).

3. Mélange sensible aux rayonnements selon la revendication 1, **caractérisé par le fait qu'**il contient 40 à 95 % du liant (a) et 5 à 60 % du dérivé acrylique ou méthacrylique (b) par rapport au poids de (a) + (b).

4. Mélange sensible aux rayonnements selon la revendication 1, **caractérisé par le fait qu'**il contient de 0,05 à 10 %, par rapport au poids des constituants non volatils, de l'inducteur de polymérisation c).

5. Mélange sensible aux rayonnements selon la revendication 1, **caractérisé par le fait que** les motifs d'alcool vinylique du polymère (a₁) sont estérifiés en partie par de l'acide acrylique ou méthacrylique.

6. Mélange sensible aux rayonnements selon la revendication 1, **caractérisé par le fait que** le polymère (a₂) est un homo- ou copolymère de la vinylpyrrrolidone, du vinylimidazole, de la vinylimidazoline, du vinyloxazole, de la vinyloxazoline ou du vinylformamide.

7. Plaque d'impression typographique sensible aux rayonnements à support de couches à dimensions stables et une couche sensible aux rayonnements consistant en un mélange selon l'une des revendications 1 à 6.

8. Plaque d'impression typographique sensible aux rayonnements selon la revendication 7, **caractérisé par le fait que**, sur la couche sensible aux rayonnements, elle porte une couche de couverture transparente soluble dans l'eau ou dispersable dans l'eau.

9. Plaque d'impression typorgraphique sensible aux rayonnements selon la revendication 7 ou 8, **caractérisée par le fait qu'**elle porte en surface une feuille de couverture détachable.

10. Procédé pour préparer une forme d'impression typographique, **caractérisé par le fait que** l'on expose une plaque d'impression typographique selon l'une des revendications 7 à 9 à des radiations actiniques avec formation d'une image ; le cas échéant, avant ou après l'exposition, on détache la feuille de couverture et on élimine les régions non exposées de la couche sensible aux rayonnements, éventuellement avec la couche de couverture transparente, par lavage avec de l'eau ou une solution aqueuse.
